# EUROPEAN PATENT SPECIFICATION

(11) **EP 4 050 356 B1**
(45) Date of publication and mention of the grant of the patent: **18.09.2024**
(21) Application number: 22158033.5
(22) Date of filing: 22.02.2022
(51) Int. Cl.: G01R 31/3835, G01R 31/396, H02J 7/00

(54) **BATTERY MANAGEMENT SYSTEM**
BATTERIEVERWALTUNGSSYSTEM
SYSTÈME DE GESTION DE BATTERIE

(30) Priority: 23.02.2021 KR 20210023915
(43) Date of publication of application: 31.08.2022
(73) Proprietor: Samsung SDI Co., Ltd., Yongin-si, Gyeonggi-do 17084 (KR)
(72) Inventor: HONG, Sang Jin, 17084 Yongin-si (KR); SIM, Sang Bong, 17084 Yongin-si (KR)
(74) Representative: Marks & Clerk LLP

(56) References cited:
- EP-A1- 3 598 154
- US-A1- 2009 309 545
- US-A1- 2012 146 652
- US-A1- 2012 194 135
- US-A1- 2014 253 135
- US-A1- 2017 271 888

## Description

### BACKGROUND

### 1. Field

Embodiments relate to a battery management system.

### 2. Description of the Related Art

Unlike a primary battery, which is not rechargeable, a secondary battery can be charged and discharged. Low-capacity secondary batteries may be used for, e.g., portable small-sized electronic devices, e.g., a smart phone, a feature phone, a notebook computer, a camcorder, and the like, and high-capacity secondary batteries may be used for, e.g., driving a motor for a hybrid car, an electric vehicle, a power storage cell, and the like.

The above information disclosed in this Background section is only for enhancement of understanding of the background of the described technology and therefore it may contain information that does not form the prior art that is already known in this country to a person of ordinary skill in the art.

EP 3 598 154 A1 discloses a sampling detection circuit and a method for detecting a circuit malfunction.

US 2014/0253135 A1 discloses an apparatus and method for diagnosing an abnormality in a cell balancing circuit in a battery pack including a plurality of cells corresponding to each cell balancing circuit.

US 2012/0146652 A1 discloses an assembled battery system including a plurality of serially connected battery cells, and voltage detecting lines connectable at one end to electrodes of the battery cells of the assembled battery.

### SUMMARY

An embodiment is directed to a battery management system as described in claim 1, and a method according to claim 8.

### BRIEF DESCRIPTION OF DRAWINGS

Features will become apparent to those of skill in the art by describing in detail example embodiments with reference to the attached drawings in which:
FIG. 1 is a schematic diagram illustrating a battery management system according to an example embodiment.
FIGS. 2A and 2B are schematic diagrams for explaining a method for detecting the disconnection of a sensing line in a battery management system.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey example implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

As used herein, the term "and/or" includes any and all combinations of one or more of the associated listed items. In addition, it will be understood that when an element A is referred to as being "connected to" an element B, the element A can be directly connected to the element B or an intervening element C may be present therebetween such that the element A and the element B are indirectly connected to each other.

The terminology used herein is for the purpose of describing particular embodiments only and is not intended to be limiting of the disclosure. As used herein, the singular forms are intended to include the plural forms as well, unless the context clearly indicates otherwise. It will be further understood that the terms "comprise or include" and/or "comprising or including," when used in this specification, specify the presence of stated features, numbers, steps, operations, elements, and/or components, but do not preclude the presence or addition of one or more other features, numbers, steps, operations, elements, components, and/or groups thereof.

It will be understood that, although the terms first, second, etc. may be used herein to describe various members, elements, regions, layers and/or sections, these members, elements, regions, layers and/or sections should not be limited by these terms. These terms are only used to distinguish one member, element, region, layer and/or section from another. Thus, for example, a first member, a first element, a first region, a first layer and/or a first section discussed below could be termed a second member, a second element, a second region, a second layer and/or a second section without departing from the teachings of the present disclosure.

In addition, a control unit (controller) and/or other related devices or components according to the present disclosure may be implemented using any suitable hardware, firmware (e.g., application specific semiconductor), software, or a suitable combination of software, firmware, and hardware. For example, various components of the control unit and/or other related devices or parts according to the present disclosure may be formed on one integrated circuit chip or on separate integrated circuit chips. In addition, various components of the control unit may be implemented on a flexible printed circuit film, and may be formed on a tape carrier package, a printed circuit board, or the same substrate as the control unit.

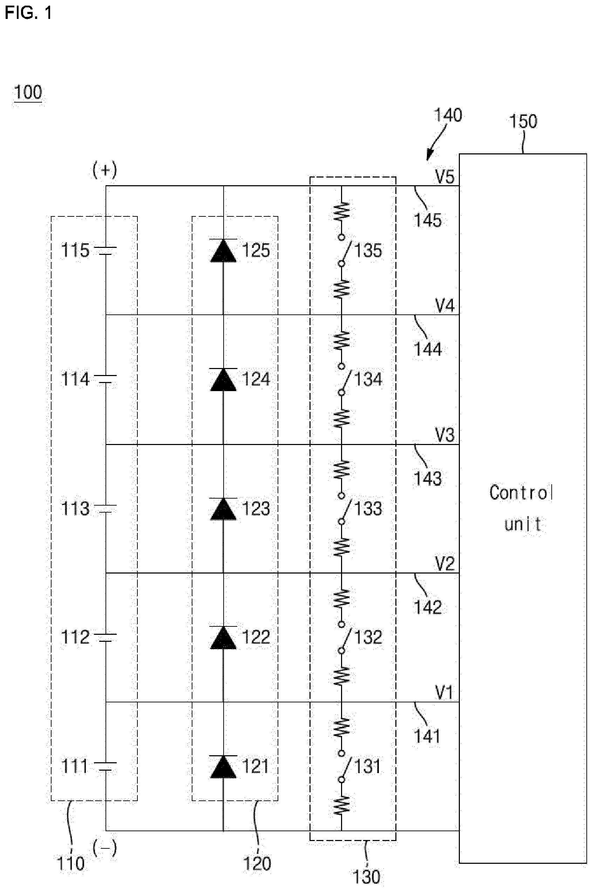

FIG. 1 is a schematic diagram illustrating a battery management system according to an example embodiment.

Referring to FIG. 1, a battery management system 100 according to an example embodiment includes a diode unit 120, a switch unit 130, a sensing unit 140, and a control unit 150. The battery management system 100 may be connected to a battery 110, to manage the battery 110.

The battery 110 may include a plurality of battery cells 111, 112, 113, 114, and 115, and may be charged or discharged at a constant voltage. In an example embodiment, the battery 110 may include a plurality of battery cells 111, 112, 113, 114, and 115 connected in series.

Although the battery 110 is illustrated in FIG. 1 as having five battery cells 111, 112, 113, 114, and 115 connected in series, the number of battery cells may be greater or less than five. For the sake of explanation, the battery 110 will be described as including a first battery cell 111, a second battery cell 112, a third battery cell 113, a fourth battery cell 114, and a fifth battery cell 115.

The first battery cell 111 may be a cell located at a minus terminal side of the battery 110, and the fifth battery cell 115 may be a cell located at a plus terminal side of the battery 110. The first battery cell 111 may be referred to as a lowermost battery cell, and the fifth battery cell 115 may be referred to as an uppermost battery cell.

The diode unit 120 may include a plurality of diodes 121, 122, 123, 124, and 125 connected in parallel to each of the plurality of battery cells 111, 112, 113, 114, 115. The number of diodes 121, 122, 123, 124, and 125 may correspond to the number of battery cells 111, 112, 113, 114 and 115. For example, the diode unit 120 may include a first diode 121, a second diode 122, a third diode 123, a fourth diode 124, and a fifth diode 125.

The plurality of diodes 121, 122, 123, 124, and 125 may allow the voltages of the battery cells 111, 112, 113, 114 and 115 to be measured even when at least one of sensing lines is disconnected. This will be described in additional detail below.

The switch unit 130 may include a plurality of switches 131, 132, 133, 134, and 135 connected to each of the plurality of battery cells 111, 112, 113, 114, and 115. For example, the switch unit 130 may include a first switch 131, a second switch 132, a third switch 133, a fourth switch 134, and a fifth switch 135.

The respective switches 131, 132, 133, 134, and 135 may open/close discharge paths of the corresponding battery cells 111, 112, 113, 114, and 115.

The sensing unit 140 may include a plurality of sensing lines 141, 142, 143, 144, and 145 for sensing voltages of each of the plurality of battery cells 111, 112, 113, 114, and 115. For example, the sensing unit 140 may include a first sensing line 141, a second sensing line 142, a third sensing line 143, a fourth sensing line 144, and a fifth sensing line 145.

The plurality of sensing lines 141 , 142, 143, 144, and 145 may be connected to a plus side of each of the battery cells 111 , 112, 113 , 114 and 115.

The switch unit 130 may include a discharge resistor connected to both ends of each of the switches 131, 132, 133, 134, and 135, to perform cell balancing of the battery cells 111, 112, 113, 114, and 115. For example, a discharge resistor may be connected between each end of each of the switches 131, 132, 133, 134, and 135 and a corresponding one of the sensing lines 141 , 142, 143 , 144, and 145.

The control unit 150 may detect voltages, currents, temperatures, etc. of the respective battery cells 111, 112, 113, 114, and 115 which constitute the battery 110, and may control cell balancing for the battery 110. In an example embodiment, the control unit 150 may include a microprocessor, a central processing unit (CPU), and an application-specific integrated circuit (ASIC), such as an analog front end (AFE).

The control unit 150 may divide the switch unit 130 into an even-numbered group and an odd-numbered group. The even-numbered group may include the switches 132 and 134. The odd-numbered group may include the switches 131, 133, and 135. The control unit 150 may alternately turns on the switches 132 and 134 of the even-numbered group and the switches 131, 133, and 135 of the odd-numbered group to perform cell balancing. Accordingly, the control unit 150 may shorten the time required for cell balancing, compared to a case of sequentially balancing the plurality of battery cells 111, 112, 113, 114, and 115.

In addition, the control unit 150 may measure voltages before and after cell balancing of each of the battery cells 111, 112, 113, 114, and 115 to detect disconnection of the sensing lines 141, 142, 143, 144, and 145. This now will be described in additional detail.

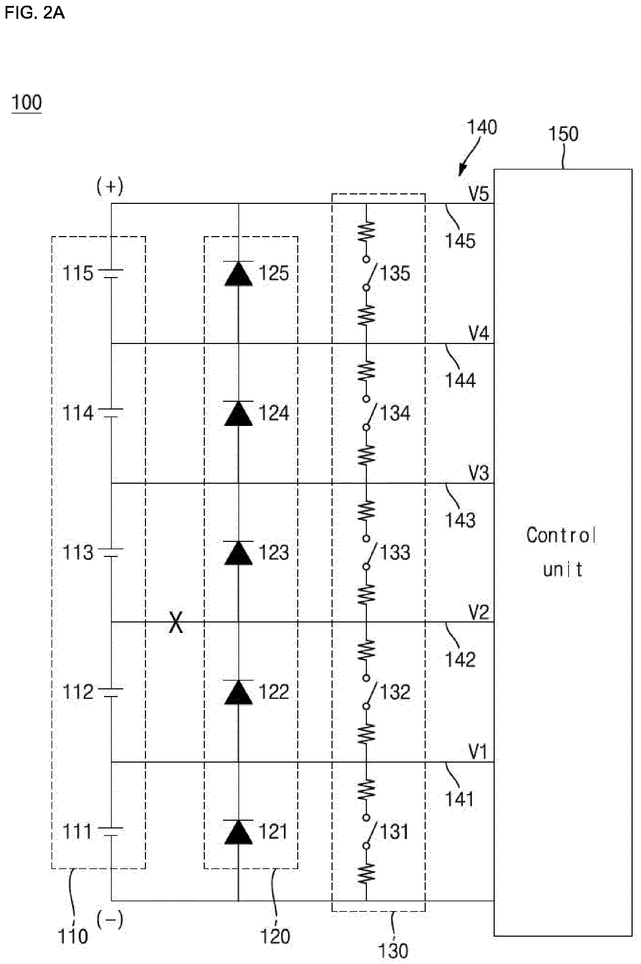

Hereinafter, a method in which the control unit 150 detects the disconnection of the sensing lines 141, 142, 143, 144, and 145 will be described in more detail. As an example, a case in which the second sensing line 142 (connected to the second battery cell 112) is disconnected (indicated by 'X' on the second sensing line 142 in FIGS. 2A-2C) will be described.

FIGS. 2A-2C are schematic diagrams for explaining a method for detecting the disconnection of a sensing line in a battery management system.

First, referring to FIG. 2A, the control unit 150 may measure voltages of the respective battery cells 111, 112, 113, 114, and 115 in a state in which the switch unit 130 is turned off, e.g., in which the switches 131, 132, 133, 134, and 135 are all open or nonconductive.

The control unit 150 may measure the voltages of the respective battery cells 111, 112, 113, 114, and 115 through the sensing unit 140. In an example embodiment, the control unit 150 may measure sensing voltages V1, V2, V3, V4, and V5 of the respective battery cells 111, 112, 113, 114, and 115 through the sensing lines 141, 142, 143, 144, and 145. The control unit 150 may obtain a difference between each of the sensing voltages V1, V2, V3, V4, and V5 of the respective battery cells 111, 112, 113, 114, and 115 and a sensing voltage of an adjacent lower battery cell to measure the voltages of the respective battery cells 111, 112, 113, 114, and 115.

Even when any one sensing line of the sensing unit 140 is disconnected (or opened), a sensing voltage may be measured from the disconnected sensing line by means of the diode unit 120. For example, referring to FIG. 2A, when the sensing voltage V3 measured from the third sensing line 143 is 9 V, and the sensing voltage V1 measured from the first sensing line 141 is 3 V, a sensing voltage V2 of 6 V, which is an intermediate voltage between the third diode 123 and the second diode 122, may be measured from the disconnected second sensing line 142 through the use of voltage division therebetween.

The control unit 150 may measure voltages of the respective battery cells 111, 112, 113, 114, and 115 by obtaining a difference between each of the sensing voltages measured from the respective sensing lines 141, 142, 143, 144, and 145 and the sensing voltage measured from an adjacent lower sensing line.

For example, the control unit 150 may obtain a difference (V3-V2) between 9 V (which is the sensing voltage V3 measured from the third sensing line 143) and 6 V (which is the sensing voltage V2 measured from the second sensing line 142), thereby determining that the voltage of the third battery cell 113 is 3 V.

Similarly, the control unit 150 may measure a difference (V2-V1) between 6 V (which is the sensing voltage V2 measured from the second sensing line 142) and 3 V (which is the sensing voltage V1 measured from the first sensing line 141), thereby determining that the voltage of the second battery cell 112 is 3 V.

In the same manner as described above, the control unit 150 may obtain the voltages of the respective battery cells 111, 112, 113, 114, and 115.

In addition, when the switch unit 130 is turned off, the control unit 150 may define a voltage difference between each of the battery cells 111, 112, 113, 114, and 115 and an adjacent upper battery cell as a first upper voltage difference and a voltage difference between each of the battery cells 111, 112, 113, 114, and 115 and an adjacent lower battery cell as a first lower voltage difference, to then store the same in a storage unit (not shown). Here, the first lower voltage difference means the voltage of each of the battery cells 111, 112, 113, 114, and 115.

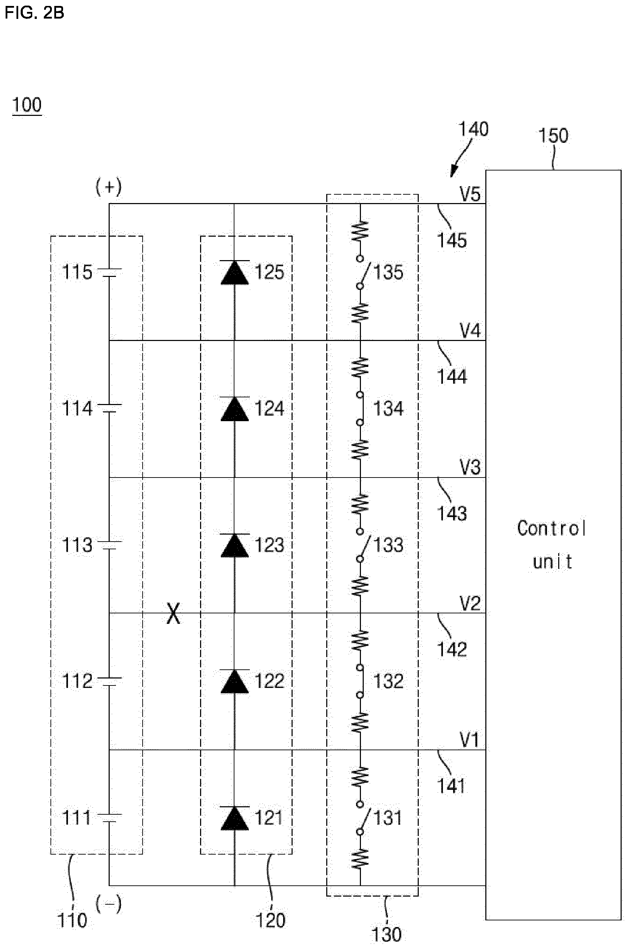

Next, referring to FIG. 2B, the control unit 150 may turn on the switches 132 and 134 of the even-numbered group of the switch unit 130 to perform cell balancing for a predetermined period of time, and may then measure the sensing voltages of the even-numbered battery cells 112 and 114 and then turn off the switches 132 and 134 of the even-numbered group.

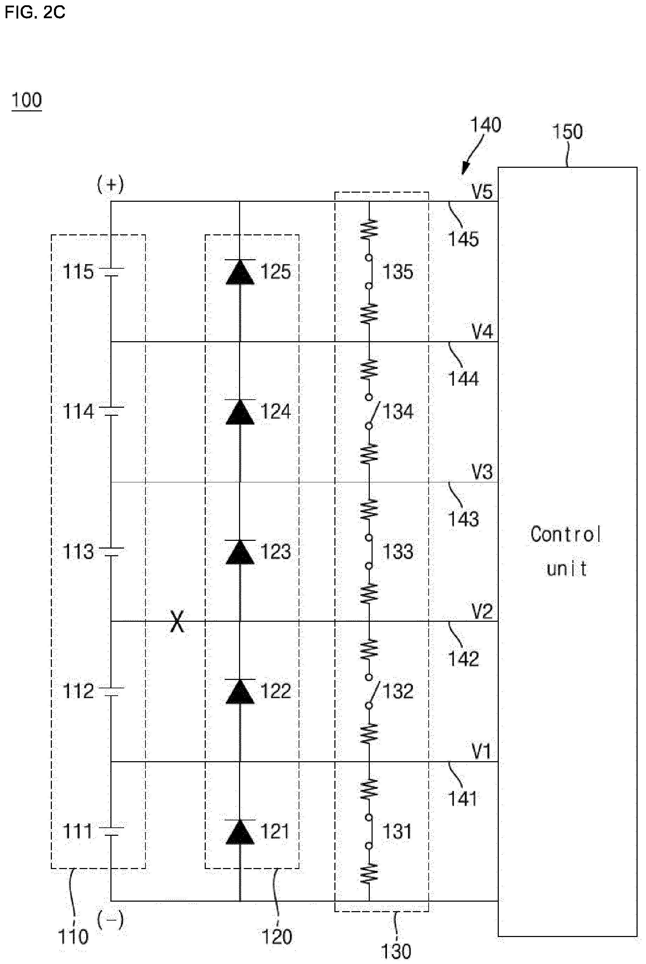

Then, referring to FIG. 2C, the control unit 150 may turn on the switches 131, 133, and 135 of the odd-numbered group to perform cell balancing for a predetermined period of time, and may then measure the sensing voltages of the odd-numbered battery cells 111, 113, and 115 and then turn off the switches 131, 133, and 135 of the odd-numbered group.

In an example embodiment, the cell balancing time may be set for a period of several seconds.

When the sensing line is disconnected during cell balancing, the sensing voltage of the corresponding battery cell is measured as being similar to the sensing voltage measured at the sensing line connected to the lower battery cell. Therefore, after cell balancing, the voltage difference between the sensing voltage of each battery cell and the sensing voltage of an adjacent lower battery cell becomes relatively lower than the voltage difference before cell balancing. In other words, in the battery cell connected to the disconnected sensing line, the voltage after cell balancing becomes lower than the voltage before cell balancing. In addition, since the voltage of the battery cell connected to the disconnected sensing line is lowered, the voltage of an adjacent upper battery cell is relatively increased. In addition, the control unit 150 may define, when the switch unit 130 is turned on, a voltage difference between each of the battery cells 111, 112, 113, 114, and 115 and an adjacent upper battery cell as a second upper voltage difference and a voltage difference between each of the battery cells 111, 112, 113, 114, and 115 and an adjacent lower battery cell as a second lower voltage difference to then store the same in the storage unit. Here, the second lower voltage difference means the voltage of each of the battery cells 111, 112, 113, 114, and 115 after cell balancing.

As such, when the second lower voltage difference between each of the battery cells 111, 112, 113, 114, and 115 and the adjacent lower battery cell is smaller than the first lower voltage difference, the control unit 150 may determine that the sensing line of the corresponding battery cell is disconnected. In addition, when the second upper voltage difference between each of the battery cells 111, 112, 113, 114, and 115 and the adjacent upper battery cell is smaller than the second upper voltage difference, the control unit 150 may determine that the sensing line of the corresponding battery cell is disconnected.

For example, referring again to FIG. 2B, when the second switch 132 is turned on, the second battery cell 112 is not connected to the second sensing line 142, and thus the voltage V2 is measured to be about 3 V, which is similar to the voltage V1 measured from the first sensing line 141. Accordingly, the control unit 150 may obtain a difference (V2-V1) between 3 V (which is the voltage V2 measured from the second sensing line 142) and 3 V (which is the voltage V1 measured from the first sensing line 141), thereby determining that the voltage of the second battery cell 112 is 0 V. In addition, the control unit 150 may obtain a difference (V3-V2) between 9 V (which is the voltage V3 measured from the third sensing line 143) and 3 V (which is the voltage V2 measured from the second sensing line 142), thereby determining that the voltage of the third battery cell 113 is 6 V.

Thus, the control unit 150 may compare the first upper voltage difference between each of the battery cells 111, 112, 113, 114, and 115 and the upper battery cell thereof before cell balancing, with the second upper voltage difference between each of the battery cells 111, 112, 113, 114, and 115 and the upper battery cell thereof after cell balancing, and, when the second upper voltage difference is greater than the first upper voltage difference, may determine that the sensing line of the corresponding battery cell is disconnected. In addition, the control unit 150 may compare the first lower voltage difference between each of the battery cells 111, 112, 113, 114, and 115 and the lower battery cell thereof before cell balancing, with the second lower voltage difference between each of the battery cells 111, 112, 113, 114, and 115 and the lower battery cell thereof after cell balancing, and, when the second lower voltage difference is greater than the first lower voltage difference, may determine that the sensing line of the corresponding battery cell is disconnected.

By way of summation and review, in a vehicle using a secondary battery, the performance of each cell may directly affect the performance of the vehicle. Thus, a charge/discharge of each cell may be managed by measuring a voltage and current of each cell. For this, a battery management system (BMS) capable of stably controlling the corresponding cell by monitoring a state of a sensing unit that senses each cell may be used.

As described above, embodiments may provide a battery management system capable of detecting disconnection of a sensing line of a battery cell. As described above, in a battery management system according to an example embodiment, a disconnection of a sensing line may be detected by comparing a voltage difference between each battery cell and an adjacent battery cell in a state in which switches are turned off with a voltage difference between each battery cell and an adjacent battery cell after turning on the switches, thereby improving safety.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A battery management system (100), comprising:
a plurality of diodes (121, 122, 123, 124, 125) which are configured to be connected in parallel to a plurality of battery cells (111, 112, 113, 114, 115), the plurality of battery cells (111, 112, 113, 114, 115), being connected in series;
a switch unit (130) which includes a plurality of switches (131, 132, 133, 134, 135) respectively configured to be connected to the plurality of battery cells (111, 112, 113, 114, 115);
a control unit (150) which is configured to detect voltages of the plurality of battery cells (111, 112, 113, 114, 115) and is configured to perform cell balancing; and
a plurality of sensing lines (141, 142, 143, 144, 145) which are configured to connect the plurality of battery cells (111, 112, 113, 114, 115) and the control unit (150),
wherein the control unit (150) is further configured to:
measure a first upper voltage difference between each battery cell (111, 112, 113, 114, 115) and an adjacent upper battery cell in a state in which the switches (131, 132, 133, 134, 135) are turned off,
measure a second upper voltage difference between each battery cell (111, 112, 113, 114, 115) and the adjacent upper battery cell after turning on the switches (131, 132, 133, 134, 135) for a predetermined time,
when the second upper voltage difference is greater than the first upper voltage difference, determine that a sensing line of a corresponding battery cell is a disconnected sensing line,
**characterised in that** the control unit (150) is further configured to:
measure a first lower voltage difference between each battery cell (111, 112, 113, 114, 115) and an adjacent lower battery cell in a state in which the switches (131, 132, 133, 134, 135) are turned off,
measure a second lower voltage difference between each battery cell (111, 112, 113, 114, 115) and the adjacent lower battery cell after turning on the switches (131, 132, 133, 134, 135) for a predetermined time, and
when the second lower voltage difference is smaller than the first lower voltage difference, determine that the sensing line of the corresponding battery cell is disconnected.

2. The battery management system (100) as claimed in claim 1, wherein the control unit (150) is configured to use the disconnected sensing line to measure a voltage of the corresponding battery cell by dividing a voltage between a diode connected to the corresponding battery cell and a diode connected to the upper battery cell.

3. The battery management system (100) as claimed in any preceding claim, wherein, when the switches (131, 132, 133, 134, 135) are turned on, a voltage of the adjacent upper battery cell of the disconnected sensing line is increased.

4. The battery management system (100) as claimed in any one of claims 1 or 2, wherein, when the switches (131, 132, 133, 134, 135) are turned on, a voltage of the battery cell of the disconnected sensing line is decreased.

5. The battery management system (100) as claimed in any preceding claim, wherein, in a state in which the switches (131, 132, 133, 134, 135) are on, a voltage of the battery cell of the disconnected sensing line corresponds to the voltage of an adjacent lower battery cell.

6. The battery management system (100) as claimed in any preceding claim, wherein, in the switch unit (130), the switches (131, 132, 133, 134, 135) of an even-numbered group and the switches of an odd-numbered group are alternately turned on.

7. The battery management system (100) as claimed in claim 6, wherein the control unit (1500 is configured to turn on the switches (131, 132, 133, 134, 135) of the even-numbered group to measure voltages of even-numbered battery cells and then turn off the switches (131, 132, 133, 134, 135) of the even-numbered group, and turn on the switches (131, 132, 133, 134, 135) of the odd-numbered group to measure voltages of odd-numbered battery cells and then turn off the switches (131, 132, 133, 134, 135) of the odd-numbered group.

8. A method of detecting the disconnection of a sensing line in a battery management system (100)
wherein the battery management system (100), comprises:
a plurality of diodes (121, 122, 123, 124, 125) which are connected in parallel to a plurality of battery cells (111, 112, 113, 114, 115), the plurality of battery cells (111, 112, 113, 114, 115) being connected in series;
a switch unit (130) which includes a plurality of switches (131, 132, 133, 134, 135) respectively connected to the plurality of battery cells (111, 112, 113, 114, 115);
a control unit (150) which is configured to detect voltages of the plurality of battery cells (111, 112, 113, 114, 115) and performs cell balancing; and
a plurality of sensing lines (141, 142, 143, 144, 145) which connect the plurality of battery cells (111, 112, 113, 114, 115) and the control unit (150),
and wherein said method comprises:
measuring, using said control unit (150), a first upper voltage difference between each battery cell and an adjacent upper battery cell in a state in which the switches are turned off,
measuring, using said control unit, a second upper voltage difference between each battery cell (111, 112, 113, 114, 115) and the adjacent upper battery cell after turning on the switches (131, 132, 133, 134, 135) for a predetermined time,
when the second upper voltage difference is greater than the first upper voltage difference, determining, using said control unit (150), that a sensing line of a corresponding battery cell is a disconnected sensing line,
**characterised by**
measuring, using said control unit, a first lower voltage difference between each battery cell (111, 112, 113, 114, 115) and an adjacent lower battery cell in a state in which the switches (131, 132, 133, 134, 135) are turned off,
measuring, using said control unit (150), a second lower voltage difference between each battery cell (111, 112, 113, 114, 115) and the adjacent lower battery cell after turning on the switches (131, 132, 133, 134, 135) for a predetermined time, and
when the second lower voltage difference is smaller than the first lower voltage difference, determining, using said control unit (150), that the sensing line of the corresponding battery cell is disconnected.

## Patentansprüche

1. Batteriemanagementsystem (100), das Folgendes umfasst:
eine Vielzahl von Dioden (121, 122, 123, 124, 125), die zum Parallelschalten mit einer Vielzahl von Batteriezellen (111, 112, 113, 114, 115) konfiguriert sind, wobei die Vielzahl von Batteriezellen (111, 112, 113, 114, 115) in Reihe geschaltet ist;
eine Schalteinheit (130), die eine Vielzahl von Schaltern (131, 132, 133, 134, 135) einschließt, die jeweils zum Verbinden mit der Vielzahl von Batteriezellen (111, 112, 113, 114, 115) konfiguriert sind;
eine Steuereinheit (150), die zum Erkennen von Spannungen der Vielzahl von Batteriezellen (111, 112, 113, 114, 115) und zum Durchführen von Zellausgleich konfiguriert ist; und
eine Vielzahl von Messleitungen (141, 142, 143, 144, 145), die zum Verbinden der Vielzahl von Batteriezellen (111, 112, 113, 114, 115) und der Steuereinheit (150) konfiguriert sind,
wobei die Steuereinheit (150) ferner konfiguriert ist zum:
Messen einer ersten oberen Spannungsdifferenz zwischen jeder Batteriezelle (111, 112, 113, 114, 115) und einer benachbarten oberen Batteriezelle in einem Zustand, in dem die Schalter (131, 132, 133, 134, 135) ausgeschaltet sind,
Messen einer zweiten oberen Spannungsdifferenz zwischen jeder Batteriezelle (111, 112, 113, 114, 115) und der benachbarten oberen Batteriezelle nach dem Einschalten der Schalter (131, 132, 133, 134, 135) für eine vorbestimmte Zeit,
Feststellen, wenn die zweite obere Spannungsdifferenz größer ist als die erste obere Spannungsdifferenz, dass eine Messleitung einer entsprechenden Batteriezelle eine getrennte Messleitung ist,
**dadurch gekennzeichnet, dass** die Steuereinheit (150) ferner konfiguriert ist zum:
Messen einer ersten unteren Spannungsdifferenz zwischen jeder Batteriezelle (111, 112, 113, 114, 115) und einer benachbarten unteren Batteriezelle in einem Zustand, in dem die Schalter (131, 132, 133, 134, 135) ausgeschaltet sind,
Messen einer zweiten unteren Spannungsdifferenz zwischen jeder Batteriezelle (111, 112, 113, 114, 115) und der benachbarten unteren Batteriezelle nach dem Einschalten der Schalter (131, 132, 133, 134, 135) für eine vorbestimmte Zeit, und
Feststellen, wenn die zweite untere Spannungsdifferenz kleiner ist als die erste untere Spannungsdifferenz, dass die Messleitung der entsprechenden Batteriezelle getrennt ist.

2. Batteriemanagementsystem (100) nach Anspruch 1, wobei die Steuereinheit (150) zum Verwenden der getrennten Messleitung zum Messen einer Spannung der entsprechenden Batteriezelle durch Teilen einer Spannung zwischen einer mit der entsprechenden Batteriezelle verbundenen Diode und einer mit der oberen Batteriezelle verbundenen Diode konfiguriert ist.

3. Batteriemanagementsystem (100) nach einem vorhergehenden Anspruch, wobei, wenn die Schalter (131, 132, 133, 134, 135) eingeschaltet sind, eine Spannung der benachbarten oberen Batteriezelle der getrennten Messleitung erhöht wird.

4. Batteriemanagementsystem (100) nach Anspruch 1 oder 2, wobei, wenn die Schalter (131, 132, 133, 134, 135) eingeschaltet sind, eine Spannung der Batteriezelle der getrennten Messleitung verringert wird.

5. Batteriemanagementsystem (100) nach einem vorhergehenden Anspruch, wobei in einem Zustand, in dem die Schalter (131, 132, 133, 134, 135) eingeschaltet sind, eine Spannung der Batteriezelle der getrennten Messleitung der Spannung einer benachbarten niedrigeren Batteriezelle entspricht.

6. Batteriemanagementsystem (100) nach einem vorhergehenden Anspruch, wobei in der Schaltereinheit (130) die Schalter (131, 132, 133, 134, 135) einer geradzahligen Gruppe und die Schalter einer ungeradzahligen Gruppe abwechselnd eingeschaltet sind.

7. Batteriemanagementsystem (100) nach Anspruch 6, wobei die Steuereinheit (1500) konfiguriert ist zum Einschalten der Schalter (131, 132, 133, 134, 135) der geradzahligen Gruppe zum Messen von Spannungen von geradzahligen Batteriezellen und dann Ausschalten der Schalter (131, 132, 133, 134, 135) der geradzahligen Gruppe, und Einschalten der Schalter (131, 132, 133, 134, 135) der ungeradzahligen Gruppe zum Messen von Spannungen von ungeradzahligen Batteriezellen und dann Ausschalten der Schalter (131, 132, 133, 134, 135) der ungeradzahligen Gruppe.

8. Verfahren zum Erkennen der Trennung einer Messleitung in einem Batteriemanagementsystem (100), wobei das Batteriemanagementsystem (100) Folgendes umfasst:
eine Vielzahl von Dioden (121, 122, 123, 124, 125), die parallel zu einer Vielzahl von Batteriezellen (111, 112, 113, 114, 115) geschaltet sind, wobei die Vielzahl von Batteriezellen (111, 112, 113, 114, 115) in Reihe geschaltet ist;
eine Schalteinheit (130), die eine Vielzahl von Schaltern (131, 132, 133, 134, 135) einschließt, die jeweils mit der Vielzahl von Batteriezellen (111, 112, 113, 114, 115) verbunden sind;
eine Steuereinheit (150), die zum Erkennen von Spannungen der Vielzahl von Batteriezellen (111, 112, 113, 114, 115) und zum Durchführen von Zellausgleich konfiguriert ist; und
eine Vielzahl von Messleitungen (141, 142, 143, 144, 145), die die Vielzahl von Batteriezellen (111, 112, 113, 114, 115) und die Steuereinheit (150) verbinden,
und wobei das Verfahren Folgendes umfasst:
Messen, unter Verwendung der Steuereinheit (150), einer ersten oberen Spannungsdifferenz zwischen jeder Batteriezelle und einer benachbarten oberen Batteriezelle in einem Zustand, in dem die Schalter ausgeschaltet sind,
Messen, unter Verwendung der Steuereinheit, einer zweiten oberen Spannungsdifferenz zwischen jeder Batteriezelle (111, 112, 113, 114, 115) und der benachbarten oberen Batteriezelle nach dem Einschalten der Schalter (131, 132, 133, 134, 135) für eine vorbestimmte Zeit,
Feststellen, unter Verwendung der Steuereinheit (150), wenn die zweite obere Spannungsdifferenz größer ist als die erste obere Spannungsdifferenz, dass eine Messleitung einer entsprechenden Batteriezelle eine getrennte Messleitung ist,
**gekennzeichnet durch**
Messen, unter Verwendung der Steuereinheit, einer ersten unteren Spannungsdifferenz zwischen jeder Batteriezelle (111, 112, 113, 114, 115) und einer benachbarten unteren Batteriezelle in einem Zustand, in dem die Schalter (131, 132, 133, 134, 135) ausgeschaltet sind,
Messen, unter Verwendung der Steuereinheit (150), einer zweiten unteren Spannungsdifferenz zwischen jeder Batteriezelle (111, 112, 113, 114, 115) und der benachbarten unteren Batteriezelle nach dem Einschalten der Schalter (131, 132, 133, 134, 135) für eine vorbestimmte Zeit, und
Feststellen, unter Verwendung der Steuereinheit (150), wenn die zweite niedrigere Spannungsdifferenz kleiner ist als die erste niedrigere Spannungsdifferenz, dass die Messleitung der entsprechenden Batteriezelle getrennt ist.

## Revendications

1. Système de gestion de batterie (100), comprenant :
une pluralité de diodes (121, 122, 123, 124, 125) qui sont configurées pour être connectées en parallèle à une pluralité d'éléments de batterie (111, 112, 113, 114, 115), la pluralité d'éléments de batterie (111, 112, 113, 114, 115) étant connectée en série ;
une unité de commutation (130) qui inclut une pluralité d'interrupteurs (131, 132, 133, 134, 135) respectivement configurés pour être connectés à la pluralité d'éléments de batterie (111, 112, 113, 114, 115) ;
une unité de commande (150) configurée pour détecter les tensions de la pluralité d'éléments de batterie (111, 112, 113, 114, 115) et configurée pour effectuer l'équilibrage des éléments ; et
une pluralité de lignes de détection (141, 142, 143, 144, 145) configurées pour connecter la pluralité d'éléments de batterie (111, 112, 113, 114, 115) et l'unité de commande (150),
dans lequel l'unité de commande (150) est en outre configurée pour :
mesurer une première différence de tension supérieure entre chaque élément de batterie (111, 112, 113, 114, 115) et un élément de batterie supérieur adjacent dans un état dans lequel les interrupteurs (131, 132, 133, 134, 135) sont désactivés,
mesurer une deuxième différence de tension supérieure entre chaque élément de batterie (111, 112, 113, 114, 115) et l'élément de batterie supérieur adjacent après avoir activé les interrupteurs (131, 132, 133, 134, 135) pendant une durée prédéterminée,
lorsque la deuxième différence de tension supérieure est supérieure à la première différence de tension supérieure, déterminer qu'une ligne de détection d'un élément de batterie correspondant est une ligne de détection déconnectée,
**caractérisé en ce que** l'unité de commande (150) est en outre configurée pour :
mesurer une première différence de tension inférieure entre chaque élément de batterie (111, 112, 113, 114, 115) et un élément de batterie inférieur adjacent dans un état dans lequel les interrupteurs (131, 132, 133, 134, 135) sont désactivés,
mesurer une deuxième différence de tension inférieure entre chaque élément de batterie (111, 112, 113, 114, 115) et l'élément de batterie inférieur adjacent après avoir activé les interrupteurs (131, 132, 133, 134, 135) pendant une durée prédéterminée, et
lorsque la deuxième différence de tension inférieure est inférieure à la première différence de tension inférieure, déterminer que la ligne de détection de l'élément de batterie correspondant est déconnectée.

2. Système de gestion de batterie (100) selon la revendication 1, dans lequel l'unité de commande (150) est configurée pour utiliser la ligne de détection déconnectée pour mesurer une tension de l'élément de batterie correspondant en divisant une tension entre une diode connectée à l'élément de batterie correspondant et une diode connectée à l'élément de batterie supérieur.

3. Système de gestion de batterie (100) selon l'une quelconque des revendications précédentes, dans lequel, lorsque les interrupteurs (131, 132, 133, 134, 135) sont activés, une tension de l'élément de batterie supérieur adjacent de la ligne de détection déconnectée est augmentée.

4. Système de gestion de batterie (100) selon l'une quelconque des revendications 1 ou 2, dans lequel, lorsque les interrupteurs (131, 132, 133, 134, 135) sont activés, une tension de l'élément de batterie de la ligne de détection déconnectée est diminuée.

5. Système de gestion de batterie (100) selon l'une quelconque des revendications précédentes, dans lequel, dans un état dans lequel les interrupteurs (131, 132, 133, 134, 135) sont activés, une tension de l'élément de batterie de la ligne de détection déconnectée correspond à la tension d'un élément de batterie inférieur adjacent.

6. Système de gestion de batterie (100) selon l'une quelconque des revendications précédentes, dans lequel, dans l'unité de commutation (130), les interrupteurs (131, 132, 133, 134, 135) d'un groupe pair et les interrupteurs d'un groupe impair sont alternativement activés.

7. Système de gestion de batterie (100) selon la revendication 6, dans lequel l'unité de commande (1500) est configurée pour activer les interrupteurs (131, 132, 133, 134, 135) du groupe pair pour mesurer des tensions d'éléments de batterie pairs, puis pour désactiver les interrupteurs (131, 132, 133, 134, 135) du groupe pair, et activer les interrupteurs (131, 132, 133, 134, 135) du groupe impair pour mesurer des tensions d'éléments de batterie impairs, puis désactiver les interrupteurs (131, 132, 133, 134, 135) du groupe impair.

8. Procédé de détection de la déconnexion d'une ligne de détection dans un système de gestion de batterie (100), dans lequel le système de gestion de batterie (100), comprend :
une pluralité de diodes (121, 122, 123, 124, 125) qui sont connectées en parallèle à une pluralité d'éléments de batterie (111, 112, 113, 114, 115), la pluralité d'éléments de batterie (111, 112, 113, 114, 115) étant connectée en série ;
une unité de commutation (130) qui inclut une pluralité d'interrupteurs (131, 132, 133, 134, 135) respectivement connectés à la pluralité d'éléments de batterie (111, 112, 113, 114, 115) ;
une unité de commande (150) configurée pour détecter les tensions de la pluralité d'éléments de batterie (111, 112, 113, 114, 115) et effectuer l'équilibrage des éléments ; et
une pluralité de lignes de détection (141, 142, 143, 144, 145) qui connecte la pluralité d'éléments de batterie (111, 112, 113, 114, 115) et l'unité de commande (150),
et dans lequel ledit procédé comprend :
la mesure, en utilisant ladite unité de commande (150), d'une première différence de tension supérieure entre chaque élément de batterie et un élément de batterie supérieur adjacent dans un état dans lequel les interrupteurs sont désactivés,
mesurer, en utilisant ladite unité de commande, une deuxième différence de tension supérieure entre chaque élément de batterie (111, 112, 113, 114, 115) et l'élément de batterie supérieur adjacent après avoir activé les interrupteurs (131, 132, 133, 134, 135) pendant une durée prédéterminée,
lorsque la deuxième différence de tension supérieure est supérieure à la première différence de tension supérieure, la détermination, en utilisant ladite unité de commande (150), du fait qu'une ligne de détection d'un élément de batterie correspondant est une ligne de détection déconnectée,
**caractérisé par**
la mesure, en utilisant ladite unité de commande, d'une première différence de tension inférieure entre chaque élément de batterie (111, 112, 113, 114, 115) et un élément de batterie inférieur adjacent dans un état dans lequel les interrupteurs (131, 132, 133, 134, 135) sont désactivés,
la mesure, en utilisant ladite unité de commande (150), d'une deuxième différence de tension inférieure entre chaque élément de batterie (111, 112, 113, 114, 115) et l'élément de batterie inférieur adjacent après avoir activé les interrupteurs (131, 132, 133, 134, 135) pendant une durée prédéterminée, et
lorsque la deuxième différence de tension inférieure est inférieure à la première différence de tension inférieure, la détermination, en utilisant ladite unité de commande (150), du fait que la ligne de détection de l'élément de batterie correspondant est déconnectée.
